(19) Europäisches Patentamt

European Patent Office

Office européen des brevets

(11) **EP 0 618 696 B1**

(12) **EUROPEAN PATENT SPECIFICATION**

(45) Date of publication and mention
of the grant of the patent:
**04.06.2003 Bulletin 2003/23**

(51) Int Cl.⁷: **H04L 1/24**, G06F 11/26,
G01R 31/28

(21) Application number: **94302263.2**

(22) Date of filing: **29.03.1994**

(54) **In-circuit testing of components**

In-circuit-Testen von Komponenten

Tests en-circuit de composants

(84) Designated Contracting States:
**DE FR GB IT NL**

(30) Priority: **31.03.1993 GB 9306735**

(43) Date of publication of application:
**05.10.1994 Bulletin 1994/40**

(73) Proprietors:
- **TEXAS INSTRUMENTS INCORPORATED**
  **Dallas Texas 75265 (US)**
  Designated Contracting States:
  **DE FR IT NL**
- **TEXAS INSTRUMENTS LIMITED**
  **Bedford MK41 7PA (GB)**
  Designated Contracting States:
  **GB**

(72) Inventor: **Fattori, Frank**
**Bedford MK41 6AU (GB)**

(74) Representative:
**Legg, Cyrus James Grahame et al**
**ABEL & IMRAY,**
**20 Red Lion Street**
**London WC1R 4PQ (GB)**

(56) References cited:
**EP-A- 0 176 646**       **EP-A- 0 403 147**

- **IBM TECHNICAL DISCLOSURE BULLETIN, vol.**
  **30,no. 3, August 1987 NEW YORK US, pages**
  **1215-1220, 'Failure-Tolerant Self-Testing**
  **Driver/Receiver'**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

**Description**

The present invention relates to in-circuit testing and in particular to the in-circuit testing of semiconductor components, for example, the driver transistors that form part of line interface circuits.

In many electronic systems it is required to transfer data between two pieces of equipment, which are often at different locations. This data transfer is usually achieved by means of a dedicated cable connecting the two pieces of equipment. In certain instances the cable can be quite long, for example, 700 metres and in order to ensure the reliability of the data transfer specialised line driver and receiver circuits are used at each end of the cable. In order to simplify the connection of equipment from different manufacturers, standards for the signal transmission along the cables have been adopted which define the electrical characteristics of the line driver and receiver circuits. Examples of these standards are EIA-RS232, EIA-RS432 and EIA-RS422.

Taking the standard EIA-RS232 as an example, the output voltage of the data transmitter must be more negative than -5 volts for a logic 1 to be deduced (marking state) and more positive than +5 volts for a logic 0 (spacing state). When no data is being sent, the output of the transmitter is in the marking state, that is to say at a voltage more negative than -5 volts.

Typically, data transmission and reception is achieved by the transmission of signals representative of logic 1 and logic 0 respectively.

Line interface circuits include the line drivers and receivers and are susceptible to failures such as those induced by shorting together of two conductors within a cable or electrical overstress. Particularly vulnerable are the output driver stage transistors of the driver and the input transistors of the receiver. In a typical driver arrangement, for example, there will be two output driver transistors arranged in a push/pull configuration, with a high sided driver to pull the driven line up to or above the spacing state voltage and a low side driver to pull the driven line down to below the marking state voltage.

It is essential to be able to test line interface circuits to ensure their functionality. The common form of test is the loop back test which can be performed by removing the connection to the line from the interface and replacing it with another connector in which the driver or drivers in the interface are directly connected to an associated line receiver or receivers. In the test, data is sent from a line driver and its correct receipt by a receiver can be checked. In the typical situation where an input/output controller provides data to and received signals from the line interface, the check may be simply that the data received via loop back was the same as that transmitted. Using this test a fault can be traced to an individual driver receiver pair or by deduction to a problem within the cable itself.

United States Patent Number 5,128,962 describes an improvement to the classical loop back test wherein transmitter and receiver stages may be tested to a substantial extent without disconnection of the data transfer lines with the attributes of a loop back test.

The IBM Technical Disclosure Bulletin, 30 (1987) Aug., No 3, at pages 1215 to 1220, discloses a testable line driver/receiver. In normal operation, the driver provides voltage signals on the line and the receiver receives voltage signals. In the test mode, however, both the driver and receiver are switched to a mode where they both receive a test current signal placed on the line by a voltage controlled current source provided specially for the testing mode. The test current is modulated and the outputs of the driver and receiver are compared to see if they both reproduce the modulation.

It is an object of the present invention to provide an in-circuit testing arrangement and method for semiconductor devices, for example the driver transistors and receiver transistors that may be found in line interface circuits. It is a further object of the invention to provide a test arrangement that may be integrated together with the semiconductor devices to be tested.

According to the present invention there are provided a testable current sourcing stage, a line interface circuit comprising that and methods of testing those as claimed in the appended claims.

In order that features and advantages of the present invention may be more fully appreciated, embodiments will now be described by way of example only and with reference to the accompanying diagrammatic drawings, in which:

Figure 1 shows the pin assignment of a quadruple driver receiver with loop back in a 28 pin package;

Figure 2 shows the operation of the device of Figure 1 in a logical representation;

Figure 3 is a functional block diagram of the device in Figure 1;

Figure 4 shows the low side driver and associated testing circuitry;

Figure 5 represents the reference generator for the low side testing circuitry;

Figure 6 represents the high side driver and associated testing circuitry;

Figure 7 represents the reference generator for the high side driver test circuitry;

Figure 8 represents the receiver stage;

Figure 9 represents an overall loop back test arrangement; and

Figure 10 represents an alternative form of reference generator for high side testing.

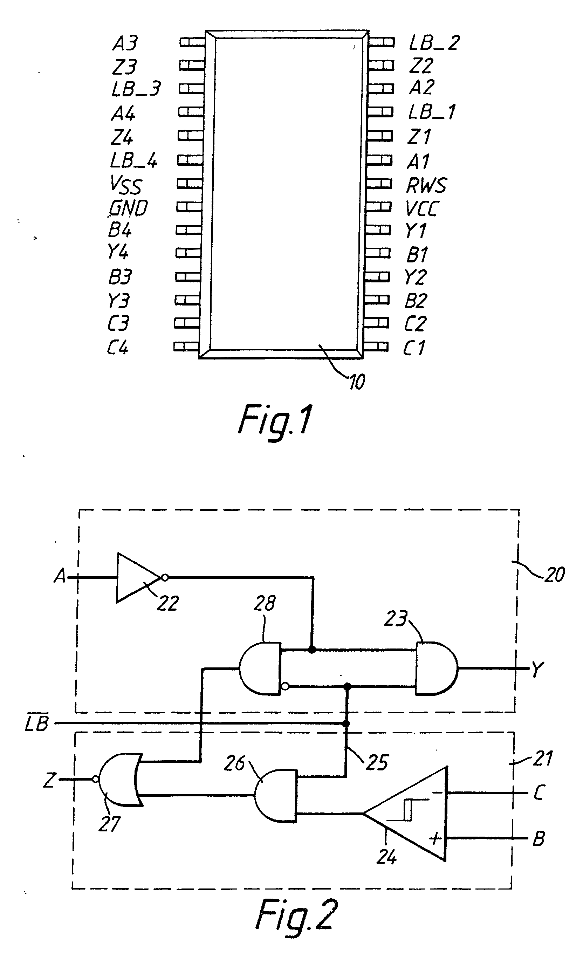

A line interface unit in accordance with the present invention may be formed as an integrated circuit in a single monolithic silicon structure. A number, for example, 4 of independent drivers and receivers may be integrated together with common power supply connections and assembled into a 28 pin package 10 (Figure 1) in which pins labelled A1, A2, A3 and A4 respectively represent data input pins of 4 independent drivers and the pins labelled Y represent the driver outputs. Similarly, pins labelled C and B are respectively the differential inputs of a receiver having an output labelled Z. Inputs LB1, LB2, LB3 and LB4 are provided individually to allow the control of a loop back mode for each driver/receiver pair. Positive (Vcc) and negative (Vss) power supplies may be connected with respect to a ground pin (GND). A pin is also provided for connection of an external component to adjust driver slew rate (RWS).

There are two modes of operation for each driver receiver pair selectable by a logic level applied to the relevant LB input pin. In normal mode operation the device performs as four independent driver receiver pairs. In loop back mode, the signal from each driver output is fed back via internal circuitry to its associated receiver input. If the device is operating correctly, the receiver output signal will be the same as the driver input signal. Faults within the device produce inconsistent data at the receiver output. Each transmitter receiver pair can be individually set into a loop back mode by applying a logic low on the associated LB input pin. If activated, the circuit tries to force a marking state (-4 to -6 volts in accordance with the RS-423 standard, for example) onto the associated driver output. Any data input to the driver propogates through the driver without changing the voltage on the output; however internal circuitry interrogates the driver output stage to check for integrity of the driver function, especially the output stage. This information is gated with the input data and caused to propogate to the receiver circuit, thereby also testing the receiver integrity. In this loop back mode the receiver differential input is switched off thereby making the receiver insensitive to normal RS-423 signals, but keeping the input stages running such that the input transistors can be tested. If the circuit is functional valid input data will propogate to the receiver output. A fault in the circuit will typically cause either the output data to be out of phase with the input data or the output will be stuck either low or high. With the driver outputs normally loaded and if the chip is not faulty loop back will function giving the correct output data. If the driver is shorted to either supply line or ground, loop back mode will give inconsistent data output.

An exemplary logical arrangement of a driver receiver pair in accordance with the present invention is illustrated in Figure 2. Input data is conditioned by input buffer 22 and gated via AND gate 23 of the receiver to the driver stage output Y. Differential data inputs C,B from the line attached to receiver section 21 are conditioned with hysterisis by input buffer 24 and gated via AND gate 26 and NOR gate 27 to the data output Z. This represents a normal mode of operation. In loop back mode when a logic low is applied to the input $\overline{LB}$ gate 23 is disabled so no output data appears at the line drive output Y. Data is however gated via gate 28 to the NOR 27 to the Z output. Data from the differential input pair is likewise disabled by gate 26. The truth table of the arrangement is as follows:

| A | B | C | LB_ | Z | Y |
|---|---|---|---|---|---|
| 0 | 0 | 1 | 1 | 1 | 1 |
| 1 | 0 | 1 | 1 | 1 | 0 |
| 0 | 1 | 0 | 1 | 0 | 1 |
| 1 | 1 | 0 | 1 | 0 | 0 |
| 0 | 0 | 0 | 1 | ? | 1 |
| 1 | 0 | 0 | 1 | ? | 0 |
| 0 | 1 | 1 | 1 | ? | 1 |
| 1 | 1 | 1 | 1 | ? | 0 |
| 0 | X | X | 0 | 0 | 0 |
| 1 | X | X | 0 | 1 | 0 |
| X = Don't Care | | | | | |
| ? = Either High or Low | | | | | |

from which it will be seen that when in loop back mode data appearing at the data output Z is identical to that applied to the data input A, no data being transferred to the line driver output Y and the differential inputs B and C being ineffective. A circuit realisation of the logical concept demonstrated in Figure 2 will now be described.

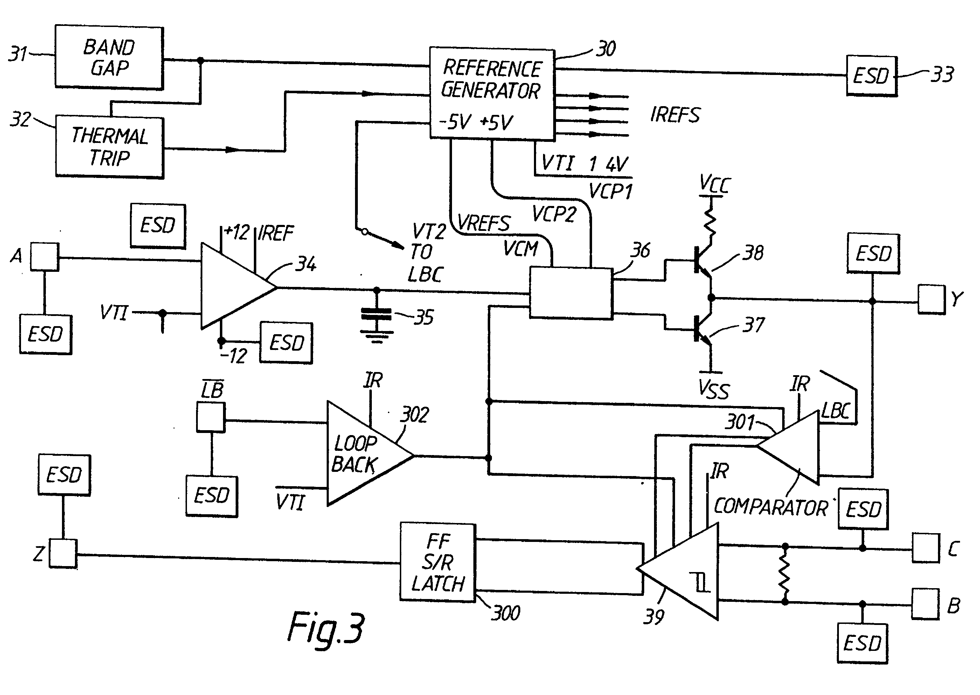

An integrated circuit which provides a line interface circuit includes a band gap reference 31 (Figure 3) providing a reference voltage to a reference generator 30. The reference generator also receives a signal from a thermally sensitive trip device 32 which acts to disable the generator and thereby close down the circuit if the integrated circuit is subject to an excessive temperature. Reference generator 30 is arranged to provide various reference currents (IREFs) and reference voltages (VREFS, VCP1, VCP2, VT1, etc). An electro-static discharge (ESD) protection network 33 is also associated with reference generator 30. It will be seen that such ESD networks are similarly connected at a plurality of points around the device. One of the four transmitter receiver pairs is also illustrated in Figure 3. Input data applied at input A is conditioned by buffer 34 and fed via an external component 35 controlling slew rate to driver circuitry 36, controlling output stage driver transistors, output stage drivers 37 and 38 which connect with the line output Y. The drivers are symbolically shown as NPN transistors in a push/pull configuration and comprise a high side driver 38 for pulling the output Y up towards Vcc into the spacing state and a low side driver 37 for sinking current from output Y to pull the output level down towards Vss into the marking state. Differential input data applied from an input line to inputs C,B is conditioned by buffer 39 and is provided at data output Z via a latch 300. The description thus far concerns the device in its normal mode of operation.

The transmitter receiver pair may be forced to enter its loop back mode by application of a logic low to input $\overline{LB}$. The loop back input signal is conditioned by a buffer 302 and applied to driver circuitry 36 and receiver buffer 39 so as to modify the operation of these two circuit elements. Data applied at an input A exercises the high and low side drivers 37 and 38 and the nature of this signal is signified by the outputs of a comparator 301 with respect to a reference voltage derived from reference generator 30. The outputs of comparator 301 are fed to receiver buffer 39 and propogate through the receiver section to the data output Z. The arrangement is such that if the device is functional, the data output at Z is the same as that applied to input A. The signals are propogated in such a way as to provide an in-circuit test of circuit components such that in the case of a fault, the signals will not propagate correctly and the data output at Z will be inconsistent with that applied to input A. The in-circuit testing of such components will now be considered.

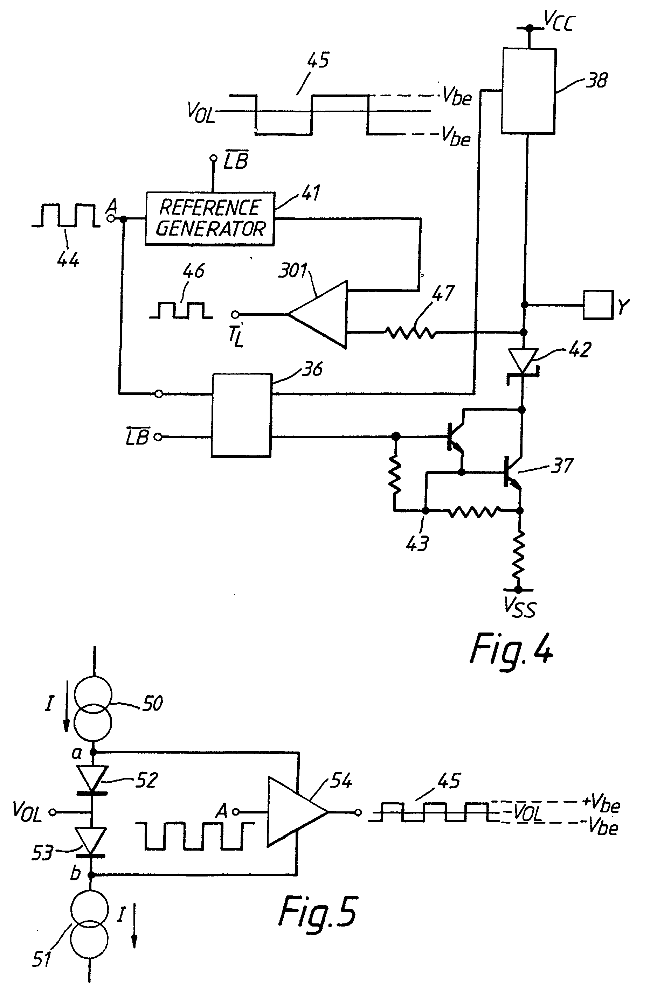

Figure 4 is illustrative of the in-circuit test applied to the low side driver transistor 37. The circuit portion in Figure 4 shows high side driver 38 (for pulling output Y to the spacing state) and low side driver 37 shown as a darlington transistor and associated biasing network 43 controlled by driver circuit 36. In the circuit portion shown in Figure 4 it will be appreciated that the normal mode of operation is that logical data applied at input A is conditioned by driver circuit 36 to control the low side driver 37. When a logic 1 is applied as input A driver circuit 36 is arranged to turn on output low- side driver transistor 37. Accordingly, output Y is pulled down to the marking state, output driver transistor 37 serving as a current sink for output Y.

Loop back mode is entered by applying a logic low level to the input $\overline{LB}$. Such application causes the driver circuit 36 to be disabled to the data input A and instead switch the low side driver transistor 37 such that it is placed into the marking state condition (no data transmitted). High side driver 36 may also be arranged to provide a small current to bias the low side driver so that the latter switches in the event of an open circuit load. Application of the loop back control also triggers reference generator 41 to provide a signal dependant upon the data applied to input A such that when input A is at logic low, a signal one forward biased junction voltage below the normal marking state output level is provided and when a logic high is applied at input A, a reference level one forward biased junction voltage above the marking level voltage is provided. The output of reference generator 41 is connected to a comparator 301. Thus, for example, when input A is repeatedly switched from logic level 0 to logic level 1 and back again, a square wave reference voltage will be provided by reference generator 41 centered on the marking level voltage (Vol) and varying between (Vol + Vbe) and (Vol - Vbe) (45). The actual voltage attained by output Y (which should be substantially the marking state voltage if the device is functional) is fed via a resistor 47 to the other input of the comparator 301. Resistor 47 serves to avoid significantly loading the output in normal mode and to protect the comparator from stress to which the input may be subjected. It will be appreciated that since one input of comparator 301 is, for example, being toggled in small amounts either side of the marking state voltage and if the voltage applied via resistor 47 (input Y) is at the marking state voltage, then a toggling data signal 46 will appear at output $T_L$. It follows that if the circuit is functional (i.e. low side driver 37 is capable of driving output Y to the marking state voltage), then output $T_L$ will toggle (46) when a varying data input (44) is applied to data input A in loop back mode. Hence, output $T_L$ provides an indication that low side transistor 37 is functional. Transistor 37 has therefore been tested in-circuit.

The generator of the reference voltage will now be discussed with reference to Figure 5.

A current I is established by any suitable means (shown symbolically as current generators 50,51) through a series connected diode pair (52,53). The mid point voltage is controlled by reference means to be substantially the voltage to be detected, that is the marking state voltage $V_{ol}$. The diode pair serves to establish voltages at circuit nodes (a) and (b) that are respectively one forward biased junction voltage ($V_{be}$) above and one forward biased junction voltage below the marking state voltage. These voltages supply an inverter 54, such that when fed with a data signal at input A, a reference signal 45 clamped at ($V_{ol}$ + $V_{be}$) and ($V_{ol}$-$V_{be}$) is provided.

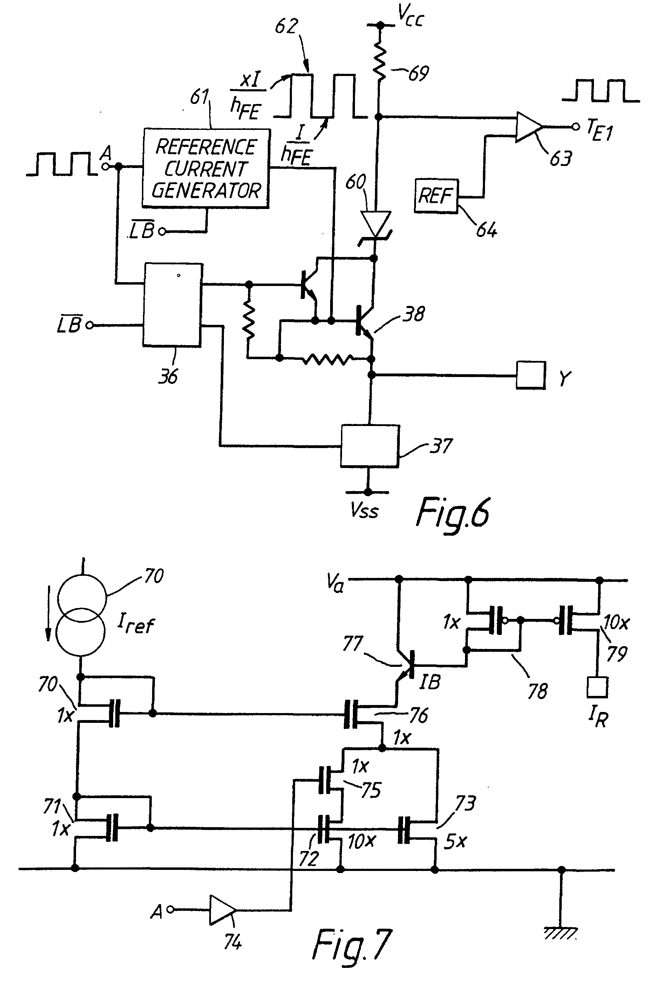

Figure 6 illustrates the arrangement for an in-circuit test of the high side driver transistor 38 and shows a portion of the circuitry of the line driver, data applied at input A controlling the driver circuit 36 to switch output driver 38 and low side driver 37 as already described. The circuit includes a protection diode 60. When a logic high is applied to input A driver circuit 36 switches high side driver transistor 38 on to pull input Y up towards Vcc to establish the spacing state. Driver 36 also simultaneously switches off the low side driver 37. This describes a normal mode of operation.

Application of a logic low to input $\overline{LB}$ causes the driver circuit 36 to switch the high and low side drivers into the marking state, that is the high side driver 38 is switched off. Hence, there is no current flow into the base of the high side darlington pair from the driver circuit 36. Application of the loop back control signal also causes reference current generator 61 to provide an output dependant upon the data applied to input A. The current levels are chosen to be factors of the inverse of the gain of a transistor chosen to be similar in properties to the high side driver transistor 38 but situated in a relatively protected circuit position. The current provided by the reference current generator 61 is injected into the base of the high side driver transistor 38. Accordingly, the collector current established will be this base current multiplied by the gain of the high side driver transistor. The collector current establishes a voltage across a resistor 69 which is provided as one input of a comparator 63, the other input of which is a reference voltage 64. The reference voltage 64 is chosen such that it is substantially midway between the upper and lower voltage levels established across resistor 69 by the upper and lower current levels respectively established therein by the chosen drive currents when the high side driver transistor 38 is substantially equal in gain to the chosen reference transistor. Thus it will be appreciated that if this latter condition is met that is the voltage across resistor 69 varies either side of the reference voltage 64, then the output of the comparator 63 at output $T_H$ will be a toggling waveform for a toggling data input A. If however, the gain of the high side driver transistor 38 is significantly different from that of the chosen transistor (for example, it is short circuit, open circuit or otherwise damaged) then the voltage developed across 69 will not vary either side of the reference, and therefore no change in the output $T_H$ will occur. Therefore, the presence of such a signal is indicative of a functional high side driver. The high side driver has therefore been tested in-circuit.

An embodiment of the reference current generator 61 will now be considered.

In the reference current generator of Figure 7, the designation "X" is used to indicate the relative size of transistors in an integrated circuit realisation. For example, if a "1X" transistor is of unit size, a "5X" transistor will occupy five times the area in integrated form, and a "10X" transistor will occupy ten times the area of the unit size transistor.

The current generator is based upon a constant current generator 70 providing a reference current $I_{REF}$. The generator is arranged to drive the input side of a current mirror configuration formed by transistors 70, 71, 76 and 73. Since transistor 73 is a 5X transistor, the current through transistor 76 will be five times $I_{REF}$, for example, if $I_{REF}$ is equal to 10 microamps, the current through transistor 76 will be 50 microamps. This current establishes a collector current through a bipolar internal reference transistor 77 which in turn establishes therein a base current that will be reduced by a factor of the current gain of the transistor 77. In the example:

$$IB1 = \frac{50 \ \mu A}{hFEint}$$

The base current is provided by a current mirror arrangement formed of transistors 78 and 79. Since transistor 79 is a 10X transistor the final current generated will be ten times the base current. That is:

$$I_{R1}=10I_{B1}=\frac{500 \ \mu A}{hFEint}$$

A data signal present on input A is conditioned by a buffer 74 and thereby controls a switching transistor 75 which acts to switch a second current mirror transistor 72 in and out of circuit dependent upon A. Since transistor 72 is 10X transistor, the current established when transistor 75 is on in dependence upon data signal A is ten times $I_{REF}$ and for an $I_{REF}$ of 10 microamps, will be 1000 microamps. This current is established in addition to that through transistor 73 by summation, thus the collector current of transistor 77 when transistor 75 is on rises to 1500 microamps, this gives:

$$I_{R2}=10I_{B2}=\frac{1500 \ \mu A}{hFEint}$$

Thus $I_R$ varies between two chosen current levels each a factor of the inverse of the current gain of internal transistor 77.

In loop back mode, this current $I_R$ is injected as base current to the high side driver output 38. The collector current will therefore be $I_R$ multiplied by the current gain of the high side driver, which if substantially identical to that of the internal transistor 77, will result in a current substantially equal to $I_B$. Therefore, in the exemplary values chosen, this current will vary between 500 and 1500 microamps. It is these values of current multiplied by the value of resistor 69 that are used to define the value of the reference voltage 64, which may be, for example, midway between the two.

Thus an in-circuit test of transistor 38 is provided with respect to an internal transistor 77. It will be appreciated that internal transistor 77 is very much protected compared with the high side driver transistor 38, and is therefore much less likely to fail in use. Hence, when in loop back mode any failure to provide a dynamic output $T_H$ in response to a data signal at input A is likely to be indicative of a damaged high side driver.

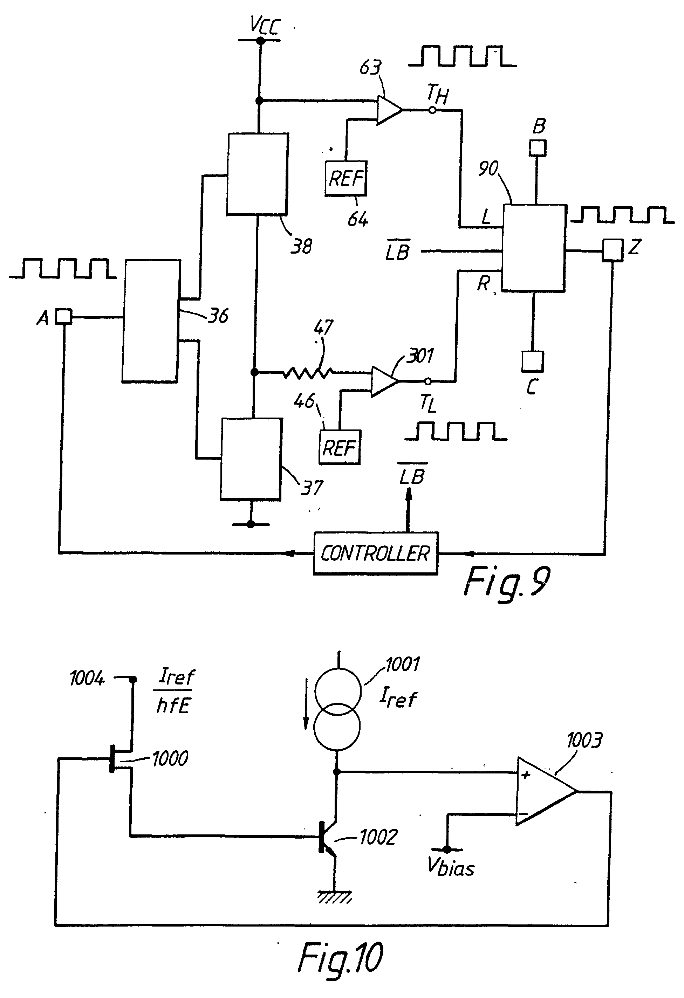

It will be noted that the current generator forces an emitter current in the internal transistor whereas in the transistor under test a base current is injected. This results in an error in the eventually established collector current of one over the current gain of the transistor times the established current. However, in practice this is negligible for transistors of suitably high current gain (in the region of 50, for example). It is possible to design an alternative current generator wherein the current demand were established as a collector current in response to an injected reference base current, and such an arrangement is shown in Figure 10.

In an alternative generator (Figure 10) a collector current $I_{REF}$ is established by a current generator arrangement 1001 in an internal reference transistor 1002. Feedback via a suitably biased operational amplifier 1003 establishes the base current at $I_{REF}/h_{FE}$, via a MOS transistor 1000, thereby providing a current $I_{REF}/$

$h_{FE}$ at terminal 1004.

In the embodiment of the present invention as thus far considered, in-circuit testing techniques and arrangements have been described for transistors, such as for transistors which may form the high side driver or the low side driver in line interface units. An in-circuit test for components of a receiver stage of a line interface circuit will now be described.

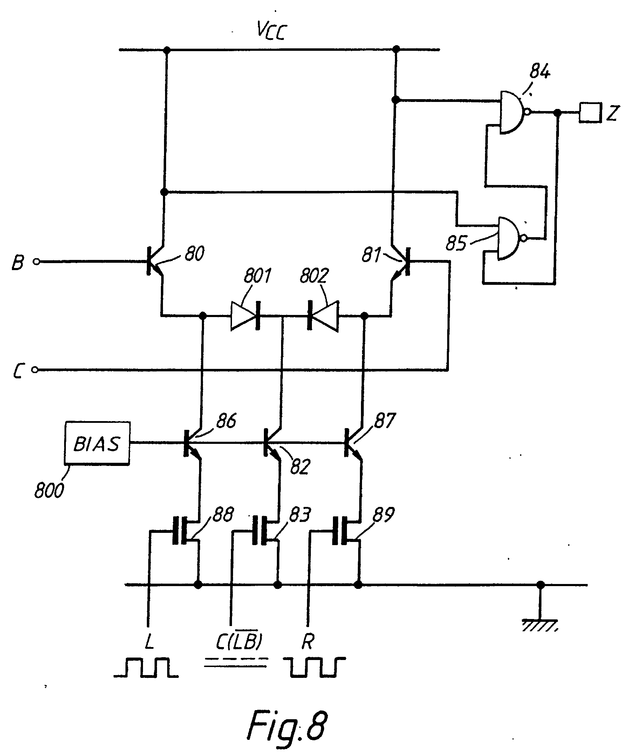

In a receiver stage (Figure 8) differential inputs (B, C) are supplied to a differential transistor pair 80, 81. Collector current for the pair is establishing by applying an input C to a switch on a transistor 83 thereby allowing a bipolar transistor 82 to establish current via diodes 801 and 802 in response to an applied bias 800. A single ended logic level output Z is provided by feeding the differential output signals from the differential transistor pair via a flip flop formed by NAND gates 84 and 85. This has described the receiver stage in a normal mode of operation.

In loop back mode the input $C_B$ controlling transistor 83 is kept low such that transistor 82 is off and no differential reference current is established. Alternatively, collector current in transistor 80 may be established by switching on transistor 88 such that current is provided by transistor 86 in response to an applied bias 800. It will be noted that this current does not establish collector current in transistor 81 since it is blocked by diode 801. Similarly, collector current may be established in transistor 81 by switching on a transistor 89 in response to an input R to allow transistor 87 to conduct in response to the applied bias 800. If inputs L and R are driven by logic levels varying in antiphase, then current will alternately flow through transistors 80 and 81 respectively to establish differential signals at the inputs to NAND gates 84 and 85. The output provided at output Z will thus be a toggling logic level. It will be realised however that if either or both of transistors 80 and 81 have been damaged and fail to conduct, the input signals necessary to provide the toggling output Z will not occur. A toggling logic level output Z is therefore indicative of functional differential receiver transistors 80, 81. These devices have therefore been tested in-circuit. The test is complete when both a high to low and low to high transistion have successfully occured.

It will be appreciated that since the differential path has been opened in this test arrangement, the differential sensitivity of transistors 80 and 81 to signals B and C has been disabled and the arrangement is therefore insensitive to normal input signals by virtue of blocking diodes 801 and 802. Each input transistor is now operated effectively in common base mode and the actual base node voltage is not critical to the current signal passing through the transistor in question. Thus the test is unaffected by unknown signals appearing on a transmission cable connected to inputs B and C. Thus, the cable need not be removed or disable for the test.

Thus far, in-circuit testing of transistors has been described that is suitable for the in-circuit testing of high side drivers, low side drivers and receivers of line interface units. It will be appreciated that in an integrated device all the tests could be separately gated to input and output pins. However, in configurations where this added pin count is undesirable, an embodiment of the invention may be configured where no extra pins are required (the arrangement of Figure 1, for example). Such an embodiment will now be considered further, and is suitable for an integrated line driver circuit.

In the arrangements of Figure 9, where portions are the same or similar to those already described, like reference numerals have been used. Only the loop back mode of the embodiment will be considered. The embodiment shows a line interface circuit comprising a transmitter receiver pair.

A signal conditioning driver buffer 36 provides drive signals to a low side driver 37 and a high side driver 38 of a transmitter portion in response to a data signal applied at input A. Since the unit is in loop back mode, the in-circuit tests already described with respect to low side driver 37 and high side driver 38 are performed in response to the input, yielding outputs $T_H$ and $T_L$ from comparators 63 and 301 respectively. If the in-circuit tests applied to drivers 37 and 38 are successful, then toggling signals will be provided at outputs $T_H$ and $T_L$. Since a common input A is used, these outputs will be in phase with the applied data signal and are arranged (by inverting one of the outputs if necessary) to be in antiphase. The line interface circuit includes a differential receiver stage 90 having inputs from the line B and C. Since the unit is in loop back mode, it is unresponsive to the inputs B and C and rather an output Z is produced in response to the signals applied to inputs L and R. As described with respect to the input in-circuit test of the receiver 90, its output Z will be a toggling level if the circuit is undamaged and quadrature logic level toggling inputs are provided respectively at these inputs. In the embodiment, the outputs of the transmitter tests $T_H$ and $T_L$ are used to provide the inputs L and R. Thus it will be appreciated that if both the high side and low side drivers of the transmitter and the receiver all pass the in-circuit tests, a toggling output will appear at Z which is substantially identical to that applied at A. In Figure 9 the input A is provided by a controller 90 and the output Z is also received thereby. A simple comparison between the output data Z and the input test pattern A yields an indication of the functionality of the line interface unit. Controller 90 also generates the only required extra test signal LB which is applied to put the unit into the loop back mode.

Controller 90 may be arranged to take corrective or alternating action in the circumstance of an unsuccessful test.

It will be appreciated that an in-circuit test of a significant porportion of a line interface circuit has been provided without recourse to large number of extra test pins (only one signal, $\overline{LB}$, being required to put the circuit into the loop back mode) that can operate with the unit still connected to the driven line without either sending outputs from the transmitter nor being susceptible to any inputs present at the receiver. A simple comparison of logic levels is all that is required in external equipment to produce an indication of a successful test.

From the foregoing, at least the following advantages of the present invention will be appreciated:

1. Monolithic solution (improved reliability and speed of testing).
2. Testing can be totally software controlled (transparent to user).
3. No signal transmitted when loopback testing is selected.
4. The tests check the ability of the driver to send a signal down a line which it is connected. If the driver can impose the correct signals the device passes. If not, it fails. Therefore it tests the cable as well as the driver.
5. Little additional circuitry only one $\overline{LB}$ pin needed per driver.
6. Rx input differential mechanism is tested.

**Claims**

1. A method of testing a current sourcing stage including a device under test (38) including the steps of:

driving the stage with a signal derived from a reference stage (61), said reference stage including a reference device (77, 1002)having a characteristic similar to a characteristic of the device under test (38) such that said driving signal depends thereon,
comparing an output of the current sourcing stage, as driven, with a reference signal defined such that said comparison, for a known to be good reference device (77, 1002), indicates whether said characteristic of the device under test (38) is acceptable.

2. A method of testing a line interface circuit having a current sourcing stage using the method of claim 1.

3. A method of testing as claimed in claim 2 wherein the line driver has a transmitter and receiver pair operable in a loop back mode, in which, if the test is successful, a data signal presented at the input of the transmitter is output at the output of the receiver, and the testing comprises comparing data at the output of the receiver with that presented at the input of the transmitter.

4. A method as claimed in claim 2 or claim 3, wherein the said reference signal from said reference stage is a non-data reference signal, said current sourcing stage has a data terminal (Y) for applying data to the line and the method comprises placing the line interface circuit in a state during testing in which no data is transmitted from the data terminal.

5. A method as claimed in claim 4, wherein said current sourcing stage includes a bipolar transistor (38).

6. A method as claimed in claim 5, wherein said reference signal is a base current injected into said transistor (38).

7. A method as claimed in claim 6, wherein the reference signal from said reference stage is switched between two different current levels such that the monitored output of the current sourcing stage toggles.

8. A method as claimed in any one of claims 5 to 7, wherein said characteristic is current gain.

9. A method as claimed in claim 4, wherein said current sourcing stage includes a field effect transistor.

10. A method as claimed in any one of claims 4 to 9, wherein the line interface circuit has a current sinking stage (37), the method including the step of:

comparing the stage output of the current sinking stage with a reference voltage to monitor whether that output is substantially pulled down to the marking state level.

11. A method as claimed in claim 10, wherein said reference voltage is switched either side of said marking state level.

12. A method as claimed in claim 11, wherein said reference voltage is switched plus and minus one forward biased base emitter junction voltage with respect to said marking state level.

13. A method as claimed in any one of claims 4 to 12, wherein said circuit has a differential input stage including first and second input transistors (80, 81) connected in a first mode of operation, the method including the steps of:

disabling the differential input stage to differential input,
switching said first transistor on and said second transistor off, said first transistor being in a second mode of operation, and
monitoring stage output (Z) of the differential input stage for consistency with a data signal that would cause said first transistor to be on and said second transistor to be off in said first mode of operation.

**14.** A method as claimed in claim 13, wherein said differential input stage is a differential pair, said stage being disabled to differential input by the step of switching off a commonly connected bias.

**15.** A method as claimed in claim 14, wherein said first transistor is turned on by the step of applying a separate bias thereto.

**16.** A method as claimed in claim 15, wherein said separate bias is alternately applied to said first and second transistors (80, 81) to provide a toggling output.

**17.** A method as claimed in claim 16, wherein bias control signals (L, R) are derived from a current sourcing stage test and a current sinking stage test and including the step of monitoring output to confirm all three tests.

**18.** A testable current sourcing stage comprising:

a device under test (38),
a reference stage (61) for providing a driving signal to the device under test, said reference stage including a reference device (77,1002) having a characteristic similar to a characteristic of the device under test such that said driving signal depends thereon, and
means (63, 64) for comparing an output of the current sourcing stage, as driven, with a reference signal defined such that said comparison, for a known to be good reference device (77,1002), indicates whether said characteristic of the device under test (38) is acceptable.

**19.** A line interface circuit having a testable current sourcing stage as claimed in claim 18.

**20.** A line interface circuit as claimed in claim 19, wherein the said reference signal from said reference stage is a non-data reference signal, said current sourcing stage has a data terminal (Y) for applying data to the line and the line interface circuit is arranged to have a state during testing in which no data is transmitted from the data terminal.

**21.** A line interface circuit as claimed in claim 20, wherein said current sourcing stage includes a bipolar transistor (38).

**22.** A line interface circuit as claimed in claim 21, wherein said reference signal from said reference stage is connected to be injected as a base current into said transistor (38).

**23.** A line interface circuit as claimed in claim 22, wherein the circuit is arranged to switch the reference signal from the reference stage between two different current levels such that the monitored output of the current sourcing stage toggles.

**24.** A line interface circuit as claimed in any one of claims 20 to 22, wherein said characteristic is current gain.

**25.** A line interface circuit as claimed in claim 20, wherein said current sourcing stage includes a field effect transistor.

**26.** A line interface circuit as claimed in any one of claims 20 to 25 comprising a current sinking stage (37) and
means (301) for comparing the stage output of the current sinking stage with a reference voltage to monitor whether that output is substantially pulled down to the marking state level.

**27.** A line interface circuit as claimed in claim 26 arranged to switch said reference voltage either side of said marking state level.

**28.** A line interface circuit as claimed in claim 27 arranged to switch said reference voltage plus and minus one forward biased base emitter junction voltage with respect to said marking state level.

**29.** A line interface circuit as claimed in any one of claims 20 to 28 comprising

a differential input stage including first and second input transistors (80, 81) connected in a first mode of operation,
means (83) for disabling the differential input stage to differential input,
means (88, 89) for switching said first transistor on and said second transistor off, said first transistor then being in a second mode of operation, and
means for monitoring stage output (Z) of the differential input stage for consistency with a data signal that would cause said first transistor to be on and said second transistor to be off in said first mode of operation.

**30.** A line interface circuit as claimed in claim 29, wherein said differential input stage is a differential pair, and said means (83) for disabling being arranged to switch off a commonly connected bias.

**31.** A line interface circuit as claimed in claim 30, wherein said means for switching said first transistor on is arranged to apply a separate bias thereto.

**32.** A line interface circuit as claimed in claim 31, wherein said means for switching said first transistor on and said second off is arranged to apply said separate bias alternately to said first and second transistors (80, 81) to provide a toggling output.

33. A line interface circuit as claimed in claim 32, wherein said means for switching said first transistor on and said second transistor off is arranged to apply bias control signals (L, R) derived from a current sourcing stage test and a current sinking stage test and the circuit comprises means for monitoring output to confirm all three tests.

34. A line interface circuit as claimed in any one of claims 19 to 33 comprising electrostatic discharge protection networks (33).

35. A line interface test circuit as claimed in any one of claims 19 to 34 wherein the line driver has a transmitter and receiver pair operable in a loop back mode, in which, if the test is successful, a data signal presented at the input of the transmitter is output at the output of the receiver.

36. A testable current sourcing stage or a line interface circuit as claimed in any one of claims 18 to 35 wherein the reference stage (61) comprises

   a bipolar reference transistor (1002) having its collector current established by a current generator arrangement (1001),
   an operational amplifier connected to compare the collector voltage with a bias voltage and providing an output, and
   a MOS transistor (1000) having its gate connected to receive the output of operational amplifier and channel connected between the base of the bipolar reference transistor (1002) and terminal (1004) providing the reference signal provided by the reference stage (61).

**Patentansprüche**

1. Verfahren zum Testen einer stromliefernden Stufe, die eine zu testende Vorrichtung (38) enthält, das die Schritte umfaßt:

   Ansteuern der Stufe mit einem Signal, das aus einer Referenzstufe (61) abgeleitet ist, wobei die Referenzstufe eine Referenzvorrichtung (77, 1002) enthält, die eine Charakteristik besitzt, die der Charakteristik der zu testenden Vorrichtung (38) ähnlich ist, derart, daß das Ansteuerungssignal von ihr abhängt,

   Vergleichen eines Ausgangssignals der stromliefernden Stufe, wenn sie angesteuert wird, mit einem Referenzsignal, das in der Weise definiert ist, daß der Vergleich mit einer bekannten und als gut befundenen Referenzvorrichtung (77, 1002) angibt, ob die Charakteristik der zu testenden Vorrichtung (38) annehmbar ist.

2. Verfahren zum Testen einer Leitungsschnittstellenschaltung, die eine stromliefernde Stufe aufweist, unter Verwendung des Verfahrens nach Anspruch 1.

3. Testverfahren nach Anspruch 2, bei dem der Leitungstreiber ein Sender-/ Empfänger-Paar besitzt, das in einer Rückschleifbetriebsart betreibbar ist, in der dann, wenn der Test erfolgreich ist, ein am Eingang des Senders anliegendes Datensignal am Ausgang des Empfängers ausgegeben wird, wobei der Test das Vergleichen der Daten am Ausgang des Empfängers mit jenen, die am Eingang des Senders anliegen, umfaßt.

4. Verfahren nach Anspruch 2 oder Anspruch 3, bei dem das Referenzsignal von der Referenzstufe ein Nichtdaten-Referenzsignal ist, die stromliefernde Stufe einen Datenanschluß (Y) für die Eingabe von Daten in die Leitung besitzt und das Verfahren das Versetzen der Leitungsschnittstellenschaltung während des Testens in einen Zustand, in dem keine Daten vom Datenanschluß gesendet werden, umfaßt.

5. Verfahren nach Anspruch 4, bei dem die stromliefernde Stufe einen Bipolartransistor (38) enthält.

6. Verfahren nach Anspruch 5, bei dem das Referenzsignal ein Basisstrom ist, der in den Transistor (38) eingespeist wird.

7. Verfahren nach Anspruch 6, bei dem das Referenzsignal von der Referenzstufe zwischen zwei verschiedenen Strompegeln umgeschaltet wird, so daß der überwachte Ausgang der stromliefernden Stufe hin und her wechselt.

8. Verfahren nach einem der Ansprüche 5 bis 7, bei dem die Charakteristik eine Stromverstärkung ist.

9. Verfahren nach Anspruch 4, bei dem die stromliefernde Stufe einen Feldeffekttransistor enthält.

10. Verfahren nach einem der Ansprüche 4 bis 9, bei dem die Leitungsschnittstellenschaltung eine stromziehende Stufe (37) als Senke besitzt, wobei das Verfahren den Schritt umfaßt:

   Vergleichen des Ausgangssignals der stromziehenden Stufe mit einer Referenzspannung, um zu überwachen, ob dieses Ausgangssignal im wesentlichen auf den Markierungszustandspegel heruntergezogen wird.

**11.** Verfahren nach Anspruch 10, bei dem die Referenzspannung auf die eine oder die andere Seite des Markierungszustandspegels geschaltet wird.

**12.** Verfahren nach Anspruch 11, bei dem die Referenzspannung in bezug auf den Markierungszustandspegel um eine Vorwärts-Vorspannung des Basis/Emitter-Übergangs in Plus- oder Minusrichtung geschaltet wird.

**13.** Verfahren nach einem der Ansprüche 4 bis 12, bei dem die Schaltung eine differentielle Eingangsstufe aufweist, die einen ersten und einen zweiten Eingangstransistor (80, 81) enthält, die in einer ersten Betriebsart miteinander verbunden sind, wobei das Verfahren die Schritte enthält:

Sperren der differentiellen Eingangsstufe für ein differentielles Eingangssignal,

Durchschalten des ersten Transistors und Sperren des zweiten Transistors, wobei sich der erste Transistor in einer zweiten Betriebsart befindet, und

Überwachen des Stufen-Ausgangssignals (Z) der differentiellen Eingangsstufe auf eine Konsistenz mit einem Datensignal, das in der ersten Betriebsart den ersten Transistor durchschalten und den zweiten Transistor sperren würde.

**14.** Verfahren nach Anspruch 13, bei dem die differentielle Eingangsstufe ein differentielles Paar ist, wobei die Stufe für ein differentielles Eingangssignal durch den Schritt des Abschaltens einer gemeinsam anliegenden Vorspannung gesperrt wird.

**15.** Verfahren nach Anspruch 14, bei dem der erste Transistor durch den Schritt, bei dem an ihn eine separate Vorspannung angelegt wird, durchgeschaltet wird.

**16.** Verfahren nach Anspruch 15, bei dem die separate Vorspannung abwechselnd an den ersten und an den zweiten Transistor (80, 81) angelegt wird, um ein hin und her wechselndes Ausgangssignal zu erzeugen.

**17.** Verfahren nach Anspruch 16, bei dem die Vorspannungs-Steuersignale (L, R) aus einem Test der stromliefemden Stufe und aus einem Test der stromziehenden Stufe abgeleitet werden und das den Schritt umfaßt, bei dem das Ausgangssignal überwacht wird, um alle drei Tests zu bestätigen.

**18.** Testbare stromliefernde Stufe, mit:

einer zu testenden Vorrichtung (38),

einer Referenzstufe (61), die ein Ansteuerungssignal für die zu testende Vorrichtung bereitstellt und eine Referenzvorrichtung (77, 1002) enthält, die eine Charakteristik besitzt, die der Charakteristik der zu testenden Vorrichtung ähnlich ist, derart, daß das Ansteuerungssignal von ihr abhängt, und

Mitteln (63, 64), die ein Ausgangssignal der stromliefernden Stufe, wenn sie angesteuert wird, mit einem Referenzsignal vergleichen, das in der Weise definiert ist, daß der Vergleich für eine bekannte und für gut befundene Vorrichtung (77, 1002) angibt, ob die Charakteristik der zu testenden Vorrichtung (38) annehmbar ist.

**19.** Leitungsschnittstellenschaltung, die eine testbare stromliefernde Stufe nach Anspruch 18 aufweist.

**20.** Leitungsschnittstellenschaltung nach Anspruch 19, bei der das Referenzsignal von der Referenzstufe ein Nichtdaten-Referenzsignal ist, wobei die stromliefernde Stufe einen Datenanschluß (Y) besitzt, um Daten in die Leitung einzugeben, und die Leitungsschnittstelle so beschaffen ist, daß sie einen Zustand während des Testens besitzt, in dem vom Datenanschluß keine Daten gesendet werden.

**21.** Leitungsschnittstellenschaltung nach Anspruch 20, bei der die stromliefernde Stufe einen Bipolartransistor (38) enthält.

**22.** Leitungsschnittstellenschaltung nach Anspruch 21, bei der das Referenzsignal von der Referenzstufe so angeschlossen ist, daß es als ein Basisstrom in den Transistor (38) eingeleitet wird.

**23.** Leitungsschnittstellenschaltung nach Anspruch 22, wobei die Schaltung so beschaffen ist, daß sie das Referenzsignal von der Referenzstufe zwischen zwei verschiedenen Strompegeln schaltet, derart, daß das überwachte Ausgangssignal der stromliefemden Stufe hin und her wechselt.

**24.** Leitungsschnittstellenschaltung nach einem der Ansprüche 20 bis 22, bei der die Charakteristik eine Stromverstärkung ist.

**25.** Leitungsschnittstellenschaltung nach Anspruch 20, bei der die stromliefernde Stufe einen Feldeffekttransistor enthält.

**26.** Leitungsschnittstellenschaltung nach einem der Ansprüche 20 bis 25, die eine stromziehende Stufe (37) als Senke und

Mittel (301), die das Ausgangssignal der stromziehenden Stufe mit einer Referenzspannung vergleichen, um zu überwachen, ob das Ausgangssignal im wesentlichen zu dem Markierungszustandspegel heruntergezogen wird, umfaßt.

27. Leitungsschnittstellenschaltung nach Anspruch 26, die so beschaffen ist, daß sie die Referenzspannung auf die eine oder die andere Seite des Markierungszustandspegels schaltet.

28. Leitungsschnittstellenschaltung nach Anspruch 27, die so beschaffen ist, daß sie die Referenzspannung in bezug auf den Markierungszustandspegel um eine Vorwärtsvorspannung des Basis-Emitter-Übergangs in Plus- und Minusrichtung schaltet.

29. Leitungsschnittstellenschaltung nach einem der Ansprüche 21 bis 28, mit

einer differentiellen Eingangsstufe, die einen ersten und einen zweiten Eingangtransistor (80, 81) enthält, die in einer ersten Betriebsart miteinander verbunden sind,

Mitteln (83), die die differentielle Eingangsstufe für ein differentielles Eingangssignal sperren,

Mitteln (88, 89), die den ersten Transistor durchschalten und den zweiten Transistor sperren, wobei der erste Transistor dann in einer zweiten Betriebsart ist, und

Mitteln, die das Stufenausgangssignal (Z) der differentiellen Eingangsstufe auf Konsistenz mit einem Datensignal überwachen, das in der ersten Betriebsart den ersten Transistor durchschalten und den zweiten Transistor sperren würde.

30. Leitungsschnittstellenschaltung nach Anspruch 29, bei der die differentielle Eingangsstufe ein differentielles Paar ist und die Mittel (83) zum Sperren so beschaffen sind, daß sie eine gemeinsam angeschlossene Vorspannung abschalten.

31. Leitungsschnittstellenschaltung nach Anspruch 30, bei der die Mittel zum Durchschalten des ersten Transistors so beschaffen sind, daß sie an ihn eine separate Vorspannung anlegen.

32. Leitungsschnittstellenschaltung nach Anspruch 31, bei der die Mittel zum Durchschalten des ersten Transistors und zum Sperren des zweiten Transistors so beschaffen sind, daß sie die separate Vorspannung abwechselnd an den ersten und an den zweiten Transistor (80, 81) anlegen, um ein hin und her wechselndes Ausgangssignal zu erzeugen.

33. Leitungsschnittstellenschaltung nach Anspruch 32, bei der die Mittel zum Duchschalten des ersten Transistors und zum Sperren des zweiten Transistors so beschaffen sind, daß sie Vorspannungssteuersignale (L, R) anlegen, die aus einem Test der stromliefemden Stufe und aus einem Test der stromziehenden Stufe abgeleitet werden, wobei die Schaltung Mittel umfaßt, die das Ausgangssignal überwachen, um alle drei Tests zu bestätigen.

34. Leitungsschnittstellenschaltung nach einem der Ansprüche 19 bis 33, die Netzwerke (33) für einen Schutz vor elektrostatischer Entladung umfaßt.

35. Leitungsschnittstellen-Testschaltung nach einem der Ansprüche 19 bis 34, bei der die Leitungsansteuerungseinrichtung ein Sender-/Empfänger-Paar aufweist, das in einer Rückschleifbetriebsart betreibbar ist, in der dann, wenn der Test erfolgreich ist, ein am Eingang des Senders anliegendes Datensignal am Ausgang des Empfängers ausgegeben wird.

36. Testbare stromliefernde Stufe oder Leitungsschnittstellenschaltung nach einem der Ansprüche 18 bis 35, wobei die Referenzstufe (61) umfaßt:

einen bipolaren Referenztransistor (1002), dessen Kollektorstrom durch eine Stromgeneratoranordnung (1001) erzeugt wird,

einen Operationsverstärker, der so angeschlossen ist, daß er die Kollektorspannung mit einer Vorspannung vergleicht und ein Ausgangssignal bereitstellt, und

einen MOS-Transistor (1000), dessen Gate so angeschlossen ist, daß es das Ausgangssignal des Operationsverstärkers empfängt, und dessen Kanal zwischen die Basis des Bipolar-Referenztransistors (1002) und einen Anschluß (1004) geschaltet ist, der das von der Referenzstufe (61) bereitgestellte Referenzsignal bereitstellt.

## Revendications

1. Une méthode de tests de l'étage de départ du courant comprenant un dispositif sous test (38) comprenant les étapes de :

commande de l'étage avec un signal provenant d'un étage de référence (61), ledit étage de référence comprenant un dispositif de référence (77,1002) possédant une caractéristique semblable à la caractéristique du dispositif sous test (38) telle que ledit signal de commande dont il dépend,

comparaison de la tension de sortie de l'étage de départ du courant, pendant la commande, avec un signal de référence, défini de telle manière que ladite comparaison indique si la caractéristique du dispositif sous test (38) est acceptable, le dispositif de référence étant considéré volubile.

2. Une méthode de tests d'un circuit d'interface en ligne possédant un étage de départ du courant utilisant la méthode de la revendication 1.

3. Une méthode de tests selon la revendication 2, dans laquelle le conducteur en ligne possède un couple d'émetteur et de récepteur fonctionnant en boucle, dans lequel, si le test réussit, un signal de données présenté à l'entrée de l'émetteur est délivré à la sortie du récepteur, et les tests comprennent la comparaison des données à la sortie du récepteur avec celles présentées à l'entrée de l'émetteur.

4. Une méthode selon la revendication 2 ou la revendication 3, dans laquelle ledit signal de référence depuis ledit étage de référence est un signal de référence d'absence de données, ledit étage de départ du courant comprend un terminal de données (Y) pour appliquer des données sur la ligne, et la méthode comprend la mise en place d'un circuit d'interface en ligne dans un état pendant les tests dans lequel aucune donnée n'est transmise depuis le terminal de données.

5. Une méthode selon la revendication 4, dans laquelle l'étage de départ du courant comprend un transistor bipolaire (38).

6. Une méthode selon la revendication 5, dans laquelle le signal de référence est un courant de base injecté dans ledit transistor (38).

7. Une méthode selon la revendication 6, dans laquelle le signal de référence dudit étage de référence est commuté entre deux niveaux de courant différents, de telle façon que la tension de sortie contrôlée de l'étage de départ du courant est alternative.

8. Une méthode selon l'une des revendications 5 à 7, dans laquelle la caractéristique est le gain en courant.

9. Une méthode selon la revendication 4, dans laquelle ledit étage de départ du courant comprend un transistor à effet de champ.

10. Une méthode selon l'une des revendications 4 à 9, dans laquelle le circuit d'interface en ligne possède un étage de circulation du courant (37), la méthode comprenant l'étape de :

comparaison de la tension de sortie de l'étage de circulation du courant avec une tension de référence pour contrôler si la tension de sortie est sensiblement abaissée au niveau de position de marquage.

11. Une méthode selon la revendication 10, dans laquelle la tension de référence est commutée de chaque côté dudit niveau de position de marquage.

12. Une méthode selon la revendication 11, dans laquelle ladite tension de référence est commutée en plus et en moins par rapport à une tension de polarisation d'une fonction émetteur base passante vis à vis dudit niveau de position de marquage.

13. Une méthode selon l'une des revendications 4 à 12, dans laquelle ledit circuit possède un étage d'entrée différentielle comprenant un premier et un second transistor d'entrée (80, 81) connectés selon un premier mode de fonctionnement, la méthode comprenant les étapes de :

mise hors d'action de l'étage d'entrée différentielle en entrée différentielle,
activation dudit premier transistor et désactivation dudit second transistor, ledit premier transistor étant dans un second mode de fonctionnement, et
contrôle de la tension de sortie de l'étage (Z) de l'étage d'entrée différentielle pour identification avec un signal de données qui activerait le premier transistor et désactiverait le second transistor selon ledit premier mode de fonctionnement.

14. Une méthode selon la revendication 13, dans laquelle l'étage d'entrée différentielle est un couple différentiel, ledit étage étant désactivé en entrée différentielle par l'étape de désactivation d'une tension de polarisation commune.

15. Une méthode selon la revendication 14, dans laquelle ledit premier transistor est activé par l'étape d'application d'une tension de polarisation séparée sur ce dernier.

16. Une méthode selon la revendication 15, dans laquelle ladite tension de polarisation séparée est appliquée alternativement sur le premier et le second transistors (80, 81) pour procurer une tension de sortie alternative.

17. Une méthode selon la revendication 16, dans laquelle les signaux de commande de tension de polarisation (L, R) sont dérivés d'un test de l'étage de circulation du courant comprenant l'étape de contrôle de la tension de sortie pour valider les trois tests.

18. Un étage de départ du courant que l'on peut tester comprenant :

   un dispositif sous test (38),
   un étage de préférence (61) pour fournir un signal de commande au dispositif sous test, ledit étage de référence comprenant un dispositif de référence (77, 2002) possédant une caractéristique semblable à une caractéristique du dispositif sous test tel que le signal de transmission dont il dépend, et
   un moyen (63, 64) pour comparer la tension de sortie de l'étage de départ du courant, pendant la commande, avec un signal de référence défini de telle manière que ladite comparaison indique si la caractéristique du dispositif sous test (38) est acceptable, le dispositif de référence étant considéré comme valable (77, 2002).

19. Un circuit d'interface en ligne possédant un étage de départ du courant qui peut être testé selon la revendication 18.

20. Un circuit d'interface en ligne selon la revendication 19, dans lequel ledit signal de référence dudit étage de référence est un signal de référence d'absence de données, ledit étage de départ du courant possède un terminal de données (Y) pour appliquer des données sur la ligne, et le circuit d'interface en ligne est adapté de manière à posséder un état pendant les tests dans lequel aucune donnée n'est transmise depuis le terminal de données.

21. Un circuit d'interface en ligne selon la revendication 20, dans lequel ledit étage de départ du courant comprend un transistor bipolaire (38).

22. Un circuit d'interface en ligne selon la revendication 21, dans lequel ledit signal de référence dudit étage de référence est relié pour être injecté comme courant de base dans ledit transistor (38).

23. Un circuit d'interface en ligne selon la revendication 22, dans lequel le circuit est disposé pour commuter le signal de référence de l'étage de référence entre deux niveaux de courant différents de telle façon que la tension de sortie contrôlée de la phase de départ du courant soit alternative.

24. Un circuit d'interface en ligne selon l'une des revendications 20 à 22, dans lequel la caractéristique est le gain en courant.

25. Un circuit d'interface en ligne selon la revendication 20, dans lequel ledit étage de départ du courant comprend un transistor à effet de champ.

26. Un circuit d'interface en ligne selon l'une des revendications 20 à 25, comprenant un étage de circulation du courant (37) et
   un moyen (301) pour comparer la tension de sortie de l'étage de circulation du courant avec une tension de référence pour contrôler si la tension de sortie est sensiblement abaissée au niveau de la position de marquage.

27. Un circuit d'interface en ligne selon la revendication 26 adapté pour commuter la tension de référence au delà et en deçà dudit niveau de position de marquage.

28. Un circuit d'interface en ligne selon la revendication 27, adapté pour commuter ladite tension de référence en plus ou en moins par rapport à une tension de polarisation d'une fonction émetteur base passante vis à vis dudit niveau de position de marquage.

29. Un circuit d'interface en ligne selon l'une des revendications 20 à 28, comprenant

   un étage d'entrée différentielle comprenant un premier et un second transistor d'entrée (80, 81) connectés selon un premier mode de fonctionnement,
   un moyen (83) pour désactiver l'étage d'entrée différentielle en entrée différentielle,
   un moyen (88, 89) pour activer ledit premier transistor et désactiver ledit second transistor, ledit premier transistor étant alors dans un second mode de fonctionnement, et
   un moyen pour contrôler la tension de sortie (Z) de l'étage d'entrée différentielle pour identification avec un signal de données qui activerait ledit premier transistor et désactiverait ledit second transistor selon ledit premier mode de fonctionnement.

30. Un circuit d'interface en ligne selon la revendication 29, dans lequel l'étage d'entrée différentielle est un couple différentiel, et ledit moyen (83) pour désactiver étant disposé de manière à déconnecter une tension de polarisation commune.

31. Un circuit d'interface en ligne selon la revendication 30, dans lequel ledit moyen pour activer ledit premier transistor est adapté pour appliquer une tension de polarisation séparée sur ce denier.

32. Un circuit d'interface en ligne selon la revendication 31, dans lequel le moyen pour activer ledit premier transistor et désactiver ledit second transistor est disposé pour appliquer ladite tension de polarisation séparée alternativement sur lesdits premier et second transistors (80, 81) pour procurer la tension de sortie alternative.

33. Un circuit d'interface en ligne selon la revendication 32, dans lequel ledit moyen pour activer ledit premier transistor et désactiver ledit second transistor est adapté pour appliquer des signaux de commande de polarisation (L, R), dérivés d'un test de l'étage de départ du courant et d'un test de l'étage de circulation du courant, le circuit comprenant un moyen pour contrôler la tension de sortie pour valider les trois tests.

34. Un circuit d'interface en ligne selon l'une des revendications 19 à 33, comprenant des réseaux de protection de décharge électrostatiques (33).

35. Un circuit de test d'interface en ligne selon l'une des revendications 19 à 34, dans lequel le coupleur de périphérique en ligne possède un couple d'émetteur et de récepteur fonctionnant en boucle, dans lequel, si le test réussit, un signal de données présenté à l'entrée de l'émetteur est délivré la tension en sortie à la sortie du récepteur

36. Un étage de départ du courant qui peut être testé ou un circuit d'interface en ligne selon l'une des revendications 18 à 35, dans lequel l'étage de référence (61) comprend

un transistor de référence bipolaire (1002) dont le courant de collecteur est établi par un dispositif générateur de courant (1001),
un amplificateur opérationnel connecté pour comparer la tension de collecteur avec une tension de polarisation et délivrant une tension de sortie, et
un transistor MOS (1000) possédant une grille reliée pour recevoir la tension de sortie de l'amplificateur opérationnel et un canal relié entre la base du transistor de référence bipolaire (1002) et une borne (1004) fournissant le signal de référence fourni par l'étage de référence (61).

A3

Z3

LB_3

A4

Z4

LB_4

VSS

GND

B4

Y4

B3

Y3

C3

C4

LB_2

Z2

A2

LB_1

Z1

A1

RWS

VCC

Y1

B1

Y2

B2

C2

C1

10

## Fig.1

A

22

28

23

Y

LB

27

Z

26

25

21

24

C

B

20

## Fig.2

Fig.3

EP 0 618 696 B1

Fig.4

Fig.5

*Fig.6*

*Fig.7*

18

Fig.8

Fig.9

Fig.10

20